# EUROPEAN PATENT APPLICATION

(11) **EP 4 727 324 A2**
(43) Date of publication of application: **15.04.2026**
(21) Application number: 25203763.5
(22) Date of filing: 22.09.2025
(51) Int. Cl.: H10P 72/00, H10P 72/78

(54) **SUBSTRATE HOLDING DEVICE, SUBSTRATE PROCESSING APPARATUS, AND METHOD OF PROCESSING SUBSTRATE**

(30) Priority: 04.10.2024 JP 2024175165
(71) Applicant: SCREEN Holdings Co., Ltd., Kyoto-shi, Kyoto 602-8585 (JP)
(72) Inventor: YASUTAKE, Yosuke, Kyoto, 602-8585 (JP); ISHIKAWA, Michiaki, Kyoto, 602-8585 (JP); ISHII, Hiroaki, Kyoto, 602-8585 (JP)
(74) Representative: Kilian Kilian & Partner mbB

(57) **Abstract**

A substrate holding device includes a porous component, a supporting component, a rotation driver, and a holding driver. The porous component includes an adsorbing surface that adsorbs a film of a framed substrate. The supporting component surrounds the porous component and supports a frame of the framed substrate. The rotation driver rotates the supporting component and the porous component in unison. The holding driver includes at least one magnet disposed opposite to the frame with respect to the supporting component and separated from the supporting component, the holding driver compressively holding the frame against the supporting component by a magnetic force of the magnet.

## Description

### BACKGROUND

### Technical Field

The present disclosure relates to a substrate holding device, a substrate processing apparatus, and a method of processing a substrate.

### Description of the Background Art

Japanese Patent Application Laid-Open No. 2010-137349 discloses a wafer processing apparatus that processes a wafer. In Japanese Patent Application Laid-Open No. 2010-137349, a wafer is disposed on a ring including a mount frame and a protective film. The mount frame is annular plate-shaped, and the protective film is attached to an interior of the mount frame. The wafer is affixed to the protective film of this ring. Hereinafter, an integrated object including the wafer, the protective film, and the mount frame will be referred to as a framed wafer.

The wafer processing apparatus includes chuck tables that hold framed wafers. Each of the chuck tables includes a framework including a recess, and an adsorption pad engaged in the recess of the framework. The protective film is placed on the adsorption pad, and the mount frame is placed on the outer edge of the framework.

The adsorption pad is a porous component, and adsorbs the protective film through suction by a vacuum means. An electromagnet is embedded in the framework. The electromagnet exerts a magnetic force on the mount frame, so that the mount frame is compressively held against the framework. As such, the framed wafer is held by the chuck table.

As described above, in Japanese Patent Application Laid-Open No. 2010-137349, the electromagnet is provided in the framework. This increases the weight of the chuck tables. Thus, when a rotation driver for rotating the chuck tables is disposed, the load of the rotation driver increases.

### SUMMARY

As described above, in Japanese Patent Application Laid-Open No. 2010-137349, the electromagnet is provided in the framework. This increases the weight of the chuck tables. Thus, when a rotation driver for rotating the chuck tables is disposed, the load of the rotation driver increases.

The present disclosure is directed to a substrate holding device, a substrate processing apparatus, and a method of processing a substrate.

According to one aspect, a substrate holding device includes: a porous component including an adsorbing surface that adsorbs a film of a framed substrate, the framed substrate including an annular frame, the film attached to an interior of the frame, and a substrate provided on the film; a supporting component surrounding the porous component and supporting the frame; a rotation driver rotating the supporting component and the porous component in unison; and a holding driver including at least one magnet disposed opposite to the frame with respect to the supporting component and separated from the supporting component, the holding driver compressively holding the frame against the supporting component by a magnetic force of the magnet.

According to one aspect, the substrate processing apparatus includes the aforementioned substrate holding device; and a dispenser that dispenses a processing fluid toward the framed substrate held by the substrate holding device.

According to one aspect, a method of processing a substrate includes: compressively holding an annular frame of a framed substrate by pressing the frame against a supporting component by a magnetic force of a magnet, the framed substrate including the frame, a film attached to the frame, and the substrate provided on the film, the magnet being separated from the supporting component; adsorptively holding the film by applying a negative pressure to a porous component supporting the film; and rotating the porous component, the supporting component, and the substrate in unison, and supplying a processing fluid to the framed substrate.

These and other objects, features, aspects, and advantages of the present disclosure will become more apparent from the following detailed description of the present disclosure when taken in conjunction with the accompanying drawings.

### BRIEF DESCRIPTION OF THE DRAWINGS

FIG. 1 is a diagram schematically illustrating one example structure of a substrate processing apparatus including a substrate holding device according to Embodiment 1;
FIG. 2 is a perspective view schematically illustrating one example structure of a framed substrate;
FIG. 3 is a block diagram schematically illustrating one example configuration of a controller;
FIG. 4 is a flowchart illustrating example operations of the substrate processing apparatus;
FIG. 5 is a diagram schematically illustrating one example structure of the substrate holding device in a loading step;
FIG. 6 is a diagram schematically illustrating one example state of the substrate holding device in a magnetic force holding step;
FIG. 7 is a diagram schematically illustrating one example state of the substrate holding device in an adsorbing step;
FIG. 8 is a diagram schematically illustrating one example state of the substrate processing apparatus in a processing step;
FIG. 9 is a plan view schematically illustrating one example structure of a holding driver;
FIG. 10 is a diagram schematically illustrating one example of a substrate holding device according to Embodiment 2; and
FIG. 11 is a diagram schematically illustrating one example of the substrate holding device according to Embodiment 2.

### DESCRIPTION OF THE PREFERRED EMBODIMENTS

The present disclosure has an object of providing a technology that can reduce a load of a rotation driver.

Embodiments will be described in detail below with reference to the attached drawings. It should be noted that dimensions and the number of components are shown in exaggeration or in simplified form as appropriate for the sake of easier understanding. The same reference signs are assigned to parts having similar structures and functions, and overlapping description will be omitted in the following description.

In the following description, the same reference signs are assigned to the same constituent elements, and their names and functions are the same. Therefore, detailed description of such constituent elements may be omitted to avoid redundant description.

Even when the ordinal numbers such as "first" and "second" are used in following description, these terms are used for convenience to facilitate the understanding of the details of Embodiments. The order indicated by these ordinal numbers does not restrict the details of Embodiments.

Unless otherwise noted, the expressions indicating relative or absolute positional relationships (e.g., "in one direction", "along one direction", "parallel", "orthogonal", "central", "concentric", and "coaxial") include those exactly indicating the positional relationships and those where an angle or a distance is relatively changed within tolerance or to the extent that similar functions can be obtained. Unless otherwise noted, the expressions indicating equality (e.g., "same", "equal", "uniform", and "homogeneous") include those indicating quantitatively exact equality and those in the presence of a difference within tolerance or to the extent that similar functions can be obtained. Unless otherwise noted, the expressions indicating shapes (e.g., "rectangular" or "cylindrical") include those indicating geometrically exact shapes and those indicating, for example, roughness or a chamfer to the extent that similar advantages can be obtained. An expression "comprising", "including", "containing", or "having" a certain constituent element is not an exclusive expression for excluding the presence of the other constituent elements. An expression "at least one of A, B, and C" involves "only A", "only B", "only C", "any two of A, B, and C", and "all of A, B, and C".

### [Embodiment 1]

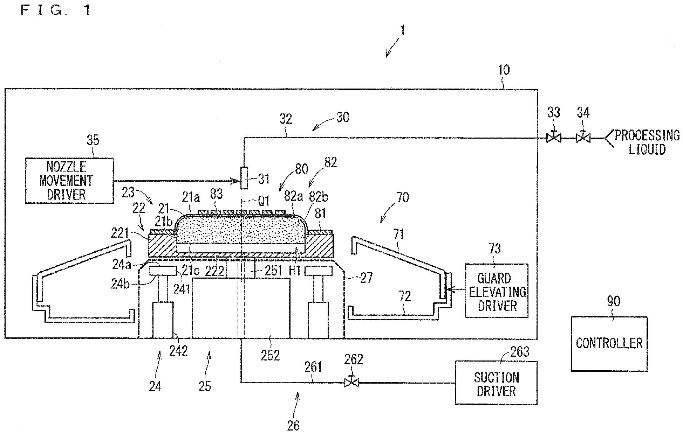

FIG. 1 is a diagram schematically illustrating one example structure of a substrate processing apparatus 1 including a substrate holding device 20 according to Embodiment 1. The substrate processing apparatus 1 is a single-wafer processing apparatus that processes framed substrates 80 one by one.

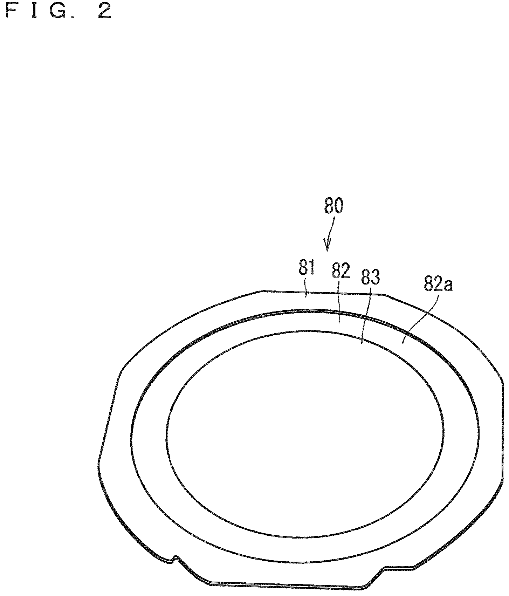

FIG. 2 is a perspective view schematically illustrating one example structure of the framed substrate 80. As illustrated in FIG. 2, the framed substrate 80 includes a frame 81, a film 82, and a substrate 83. The frame 81 is made of a material with magnetic properties (e.g., stainless steel). As illustrated in FIG. 2, the frame 81 is annular plate-shaped. In the example of FIG. 2, the inner circumferential surface of the frame 81 is of a circular shape in a plan view. An inner diameter of the frame 81 is, for example, several hundred mm (e.g., approximately 200 mm and more and 400 mm or less). The maximum value of an outer diameter of the frame 81 can be set larger than, for example, the inner diameter of the frame 81 by approximately several tens of mm. A thickness of the frame 81 is, for example, several mm (e.g., approximately 1 mm and more and 5 mm or less).

The film 82 is provided in an interior of the frame 81. Specifically, the outer edge of the film 82 is fixed to the frame 81. Thus, the film 82 closes an inner opening of the frame 81. In other words, the film 82 is exposed in the inner opening of the frame 81. The film 82 can be elastic. The film 82 is made of, for example, a synthetic resin. Hereinafter, a portion including the frame 81 and the film 82 will be also referred to as a dicing ring. The substrate 83 is provided on one main surface 82a of the film 82. The substrate 83 is attached to the main surface 82a of the film 82 through a method, for example, affixation.

In the example of FIG. 1, a plurality of the substrates 83 are affixed to the main surface 82a of the film 82. FIG. 2 omits illustration of the plurality of substrates 83 for the sake of simplicity, and illustrates the single substrate 83. The substrates 83 are, for example, semiconductor chips and referred to as dies. Each of the substrates 83 is plate-shaped. Each of the substrates 83 is affixed to the main surface 82a of the film 82 in an attitude such that its thickness direction is along the thickness direction of the frame 81 and the thickness direction of the film 82. Each of the substrates 83 is, for example, of a rectangular shape in a plan view. The plurality of substrates 83 are disposed, for example, in a matrix in a plan view. Space can be formed between the adjacent substrates 83. The plurality of substrates 83 can be formed by, for example, cutting one substrate.

As illustrated in FIG. 1, the substrate processing apparatus 1 may include a chamber 10. The chamber 10 is box-shaped, and has an internal space. The internal space corresponds to a processing space in which the framed substrate 80 is processed. The chamber 10 includes an openable and closeable loading/unloading entrance (not illustrated). A loader that is not illustrated loads the framed substrate 80 to be processed into the chamber 10 through the loading/unloading entrance. The substrate processing apparatus 1 processes the framed substrate 80, as will be described later. Then, the loader unloads the processed framed substrate 80 from the chamber 10 through the loading/unloading entrance.

In the example of FIG. 1, the substrate holding device 20 is provided in the chamber 10. The substrate holding device 20 rotates the framed substrate 80 about a rotation axis line Q1 while holding the framed substrate 80. The substrate holding device 20 holds the framed substrate 80 in an attitude such that the substrates 83 are located above the film 82. The rotation axis line Q1 is an axis line along a vertical direction, and passes, for example, through the center of a circle along the inner circumferential surface of the frame 81. Hereinafter, a circumferential direction and a radial direction of the rotation axis line Q1 will be simply referred to as a circumferential direction and a radial direction, respectively.

As illustrated in FIG. 1, the substrate holding device 20 includes a porous component 21, a base 22, a rotation driver 25, and a holding driver 24.

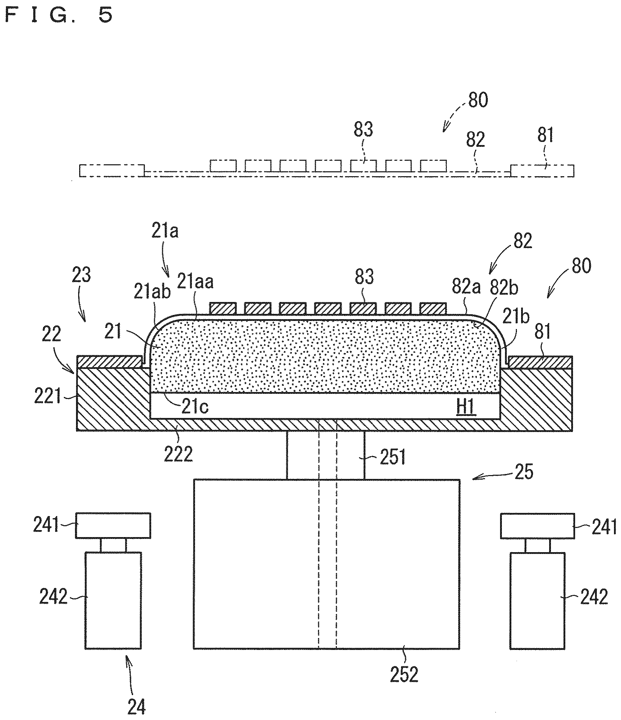

The porous component 21 is a component for adsorbing the film 82 of the framed substrate 80. The porous component 21 has porous nature, and is, for example, made of ceramic such as alumina. In the example of FIG. 1, the porous component 21 is plate-shaped, and is disposed in an attitude such that its thickness direction is along the vertical direction. The porous component 21 includes an adsorbing surface 21a, a side surface 21b, and a bottom surface 21c. The adsorbing surface 21a is in contact with a main surface 82b of the film 82, and supports the film 82. The main surface 82b is a surface opposite to the main surface 82a, and the substrates 83 are not disposed on the main surface 82b. In the example of FIG. 1, the adsorbing surface 21a corresponds to the upper surface of the porous component 21, and the main surface 82b corresponds to the lower surface of the film 82. With reference to FIG. 5, the adsorbing surface 21a may include a flat surface portion 21aa and an outer edge portion 21ab. The flat surface portion 21aa is, for example, a horizontal surface. Micro-irregularities may be formed on the flat surface portion 21aa. The flat surface portion 21aa may be of a circular shape in a plan view. The outer edge portion 21ab is a portion surrounding the flat surface portion 21aa in a plan view, and corresponds to the outer edge of the adsorbing surface 21a. In the example of FIG. 5, all of the plurality of substrates 83 are supported by the flat surface portion 21aa through the film 82. In other words, all of the plurality of substrates 83 face the flat surface portion 21aa in the vertical direction. The outer edge portion 21ab is bowed downward as progressing outward in the radial direction. The outer edge portion 21ab may be linearly sloped.

The bottom surface 21c of the porous component 21 is a surface opposite to the adsorbing surface 21a. The side surface 21b is a surface connecting the outer edge of the adsorbing surface 21a (i.e., the outer edge of the flat surface portion 21aa) to the outer edge of the bottom surface 21c. Each of the adsorbing surface 21a and the bottom surface 21c is, for example, of a circular shape in a plan view.

The base 22 includes a supporting component 221 and a bottom plate 222. The supporting component 221 is a component for supporting the frame 81 of the framed substrate 80. The supporting component 221 surrounds the porous component 21 in a plan view. The supporting component 221 is, for example, of an annular shape in a plan view. The upper surface of the supporting component 221 is, for example, a horizontal flat surface. The frame 81 is placed on the upper surface of the supporting component 221. In other words, the upper surface of the supporting component 221 is in contact with the lower surface of the frame 81. The inner circumferential surface of the supporting component 221 partially faces the side surface 21b of the porous component 21. Specifically, an upper portion of the inner circumferential surface of the supporting component 221 faces a lower portion of the side surface 21b of the porous component 21 around the entire perimeter.

In this substrate holding device 20, the adsorbing surface 21a of the porous component 21 is located above the upper surface of the supporting component 221. Thus, the framed substrate 80 is held by the substrate holding device 20 while the film 82 extends such that the plurality of substrates 83 are located above the frame 81. In this state, the film 82 can be in contact with the entire surface of the adsorbing surface 21a of the porous component 21.

The supporting component 221 protrudes below the bottom surface 21c of the porous component 21. The bottom plate 222 is connected to a lower portion of the supporting component 221 to close an inner opening of the supporting component 221. The supporting component 221 and the bottom plate 222 may be integrally formed of the same material, or formed by combining a plurality of components. The bottom plate 222 faces the bottom surface 21c of the porous component 21 across a void H1 in the vertical direction. This void H1 is surrounded by the bottom surface 21c of the porous component 21, the inner circumferential surface of the supporting component 221, and the upper surface of the bottom plate 222.

The porous component 21 may be fixed to the supporting component 221 detachably or with detaching difficulty (or undetachably). A certain sealant may seal a portion between the side surface 21b of the porous component 21 and the inner circumferential surface of the supporting component 221. For example, application of an adhesive as the sealant rigidly fixes the porous component 21 to the supporting component 221.

A suction part 26 (FIG. 1) applies a negative pressure to the porous component 21 and the void H1. Since the porous component 21 has porous nature, when the void H1 is at the negative pressure, gas enters the void H1 from the adsorbing surface 21a of the porous component 21 through the interior of the porous component 21. Consequently, the film 82 is adsorptively held against the adsorbing surface 21a of the porous component 21.

In the example of FIG. 1, the suction part 26 includes a suction pipe 261, a suction valve 262, and a suction driver 263. An upstream end of the suction pipe 261 is joined to the void H1. The upstream end of the suction pipe 261 may be connected to a center portion of the bottom plate 222 of the base 22. The suction pipe 261 may penetrate, in the vertical direction, the rotation driver 25 to be described later. A downstream end of the suction pipe 261 is connected to the suction driver 263. The suction driver 263 is controlled by a controller 90, and suctions gas in the void H1 through the suction pipe 261. The suction driver 263 is, for example, a pump. The suction valve 262 is inserted in the suction pipe 261 to switch between opening and closing the suction pipe 261. The suction valve 262 and the suction driver 263 are controlled by the controller 90.

The controller 90 operates the suction driver 263 with the suction valve 262 being opened. Consequently, a negative pressure is generated in the void H1, so that the film 82 is adsorptively held against the porous component 21.

The holding driver 24 includes magnets 241. The holding driver 24 exerts a magnetic force (e.g., a magnetic attraction force) of the magnets 241 on the frame 81 so that the frame 81 is compressively held against the supporting component 221. In the example of FIG. 1, the magnets 241 are disposed opposite to the frame 81 with respect to the supporting component 221, and are separated from the base 22 (the supporting component 221 and the bottom plate 222). For example, the magnets 241 are disposed immediately below the supporting component 221. The magnets 241 face the supporting component 221 with spacing in the vertical direction. The magnets 241 may be of an annular shape of surrounding the rotation axis line Q1.

Each of the magnets 241 has pole faces 24a and 24b. The pole face 24a is a face facing the supporting component 221 in the vertical direction, and the pole face 24b is a face opposite to the pole face 24a. The pole faces 24a and 24b have magnetic poles with opposite polarities. For example, when the pole face 24a is a north pole, the pole face 24b is a south pole.

The supporting component 221 is non-magnetic. The supporting component 221 is made of, for example, a non-magnetic material such as aluminum. Thus, the magnets 241 hardly apply a magnetic attraction force to the supporting component 221. On the other hand, the frame 81 is magnetic. Thus, when the magnetic attraction force from the magnets 244 is exerted on the frame 81, the frame 81 is attracted toward the magnets 241 and is pressed by the supporting component 221. Thus, the frame 81 is compressively held against the supporting component 221.

The holding driver 24 is controlled by the controller 90, and regulates the magnetic attraction force exerted from the magnets 241 on the frame 81. Specifically, the holding driver 24 switches between a holding state of compressively holding the frame 81 against the supporting component 221 with the magnetic attraction force and a hold releasing state of releasing a compressive hold of the frame 81 by reducing or eliminating the magnetic attraction force on the frame 81.

The magnets 241, which may be electromagnets, are permanent magnets in the example of FIG. 1. In the example of FIG. 1, the holding driver 24 includes magnet movement drivers 242. Each of the magnet movement drivers 242 moves the magnet 241 between a holding position and a hold releasing position to be described next. The holding position is a position at which the magnetic attraction force from the magnet 241 is fully exerted on the frame 81. Placement of the magnet 241 at the holding position allows the frame 81 to be compressively held against the supporting component 221 by the magnetic attraction force. FIG. 1 illustrates the magnets 241 at the respective holding positions. The hold releasing position is a position farther from the frame 81 than the holding position. For example, the hold releasing position is a position at which the magnetic attraction force from the magnet 241 is not substantially exerted on the frame 81. Placement of the magnet 241 at the hold releasing position leads to substantial elimination of the magnetic attraction force on the frame 81, which releases the compressive hold of the frame 81.

The magnet movement driver 242 may move the magnet 241 up and down. In other words, the hold releasing position may be a position lower than the holding position and a position aligned with the holding position in the vertical direction. The magnet movement drivers 242 may be, for example, air cylinders. Alternatively, each of the magnet movement drivers 242 may include a motor, and a power transmitter that transmits a driving force from the motor to the magnet 241. The power transmitter may include, for example, a ball screw mechanism or a cam mechanism. The magnet movement drivers 242 are controlled by the controller 90. A plurality of the magnet movement drivers 242 are disposed in the example of FIG. 1, which will be described later in detail.

The rotation driver 25 is controlled by the controller 90, and rotates the porous component 21 and the base 22 in unison about the rotation axis line Q1. Hereinafter, a portion including the porous component 21 and the base 22 will be also referred to as a holding table 23. Rotation of the holding table 23 about the rotation axis line Q1 rotates the framed substrate 80 held by the holding table 23 about the rotation axis line Q1.

In the example of FIG. 1, the rotation driver 25 is disposed below the holding table 23, and includes a shaft 251 and a motor 252. The shaft 251 extends downward from the lower surface of the base 22 along the vertical direction. Specifically, an upper end of the shaft 251 is connected to the center of the bottom plate 222 of the base 22, and extends along the rotation axis line Q1. The motor 252 is connected to the shaft 251. The motor 252 is controlled by the controller 90, and rotates the shaft 251 about the rotation axis line Q1. This allows the holding table 23 connected to the shaft 251 and the framed substrate 80 held by the holding table 23 to be rotated in unison about the rotation axis line Q1.

In the example of FIG. 1, the shaft 251 is a hollow shaft, and the suction pipe 261 of the suction part 26 extends through an interior of the shaft 251 along the vertical direction. An internal space of the shaft 251 may function as a suction path. In other words, the upstream end of the suction pipe 261 may be connected to the lower end of the shaft 251. As described above, a negative pressure is applied to the porous component 21 through the interior of the shaft 251 in the example of FIG. 1. Thus, the negative pressure can be applied to the porous component 21 with a simple structure.

In the example of FIG. 1, the holding driver 24 is adjacent to the rotation driver 25 in the horizontal direction, and is disposed in the space immediately below the holding table 23. The holding driver 24 is disposed, for example, on the floor of the chamber 10. The holding driver 24 is independent from the rotation driver 25, and is not rotated by driving of the rotation driver 25. For example, the holding driver 24 is non-rotational.

As described above, driving targets of the rotation driver 25 do not include the magnets 241 in the substrate holding device 20. Thus, a load of the rotation driver 25 (i.e., the weight of the holding table 23) can be reduced. Consequently, the life of the rotation driver 25 can be extended, and a smaller rotation driver 25 (i.e., the motor 252) can be employed.

In the example of FIG. 1, a driver housing component 27 is provided in the chamber 10. The driver housing component 27 houses the holding driver 24 and the motor 252. The driver housing component 27 protects the holding driver 24 and the motor 252 from a processing fluid to be described later.

The controller 90 controls the substrate holding device 20. Specifically, the controller 90 controls the holding driver 24, the rotation driver 25, and the suction part 26 as described above. Furthermore, the controller 90 can control other structures of the substrate processing apparatus 1. In the example of FIG. 1, the substrate processing apparatus 1 includes a dispenser 30 as an example of the other structures. In the example of FIG. 1, the substrate processing apparatus 1 also includes a guard part 70 as an example of the other structures. The dispenser 30 and the guard part 70 will be described later in detail.

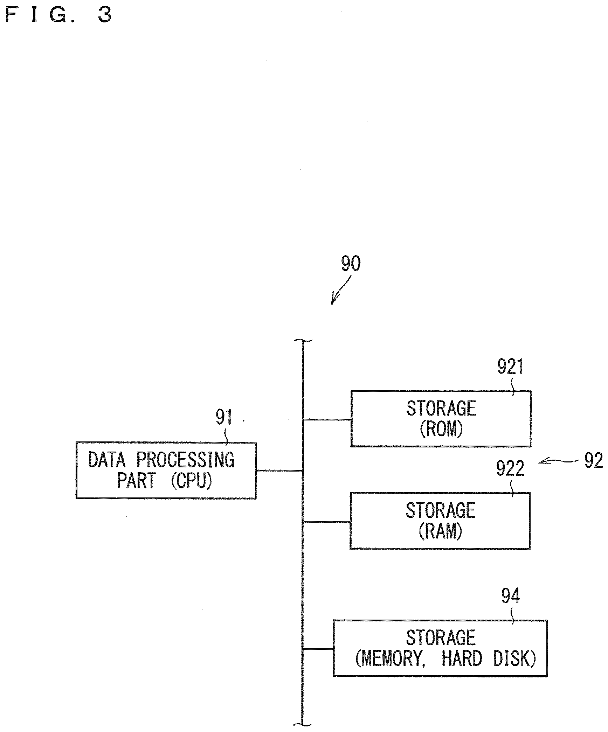

FIG. 3 is a block diagram schematically illustrating one example configuration of the controller 90. The controller 90 is an electronic circuit, and includes, for example, a data processing part 91 and a storage 92. In a specific example of FIG. 3, the data processing part 91 and the storage 92 are mutually connected through a bus. The data processing part 91 may be, for example, an arithmetic processing unit such as a central processing unit (CPU). The storage 92 may include a non-transitory storage (e.g., a read-only memory (ROM)) 921 and a transitory storage (e.g., a random-access memory (RAM)) 922. The non-transitory storage 921 may store, for example, a program for defining processes to be executed by the controller 90. The data processing part 91 executes this program, so that the controller 90 can execute the processes defined in the program. Obviously, a hardware circuit such as a dedicated logic circuit may execute a part or all the processes to be executed by the controller 90.

In the example of FIG. 3, a storage 94 is also connected to the controller 90. The storage 94 includes at least one of a memory and hard disk. The storage 94 stores various pieces of data.

### [Operations of substrate holding device]

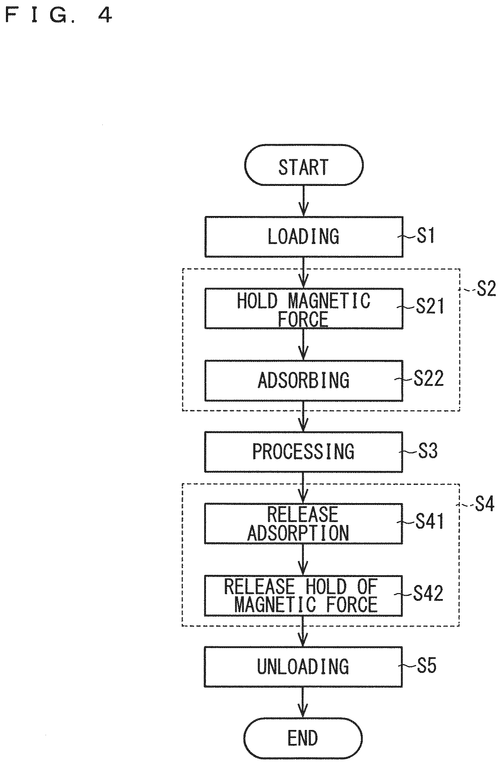

FIG. 4 is a flowchart illustrating example operations of the substrate processing apparatus 1. The procedure in FIG. 4 is implemented by controlling the constituent elements of the substrate processing apparatus 1 by the controller 90.

First, in Step S1 (a loading step), the framed substrate 80 is loaded into the chamber 10. FIG. 5 is a diagram schematically illustrating one example structure of the substrate holding device 20 in the loading step. In the example of FIG. 5, the framed substrate 80 before loading is illustrated by virtual lines. For example, a loader that is disposed outside the substrate processing apparatus 1 and is not illustrated performs this loading. The loader is also controlled by the controller 90. As illustrated in FIG. 5, the magnet movement drivers 242 stop the magnets 241 at the hold releasing positions in the loading step. Thus, the magnets 241 have not exerted the magnetic attraction force on the frame 81 yet. The holding table 23 supports the framed substrate 80 loaded into the chamber 10.

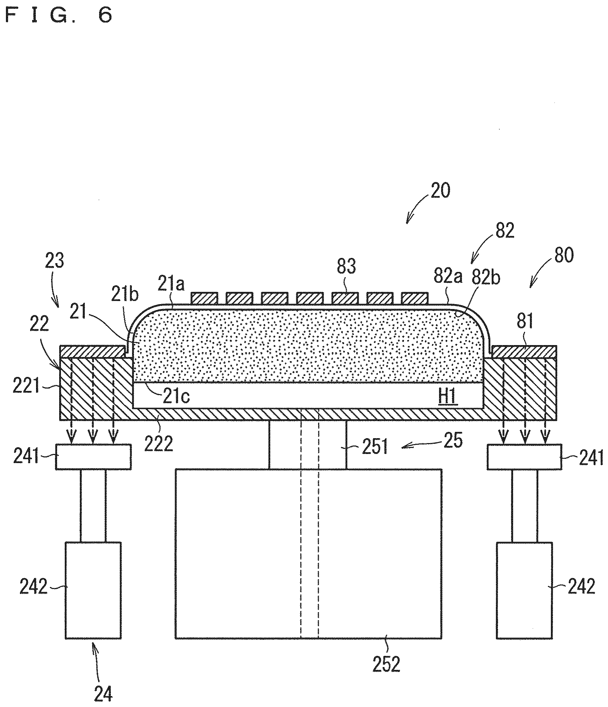

Next, the substrate holding device 20 holds the framed substrate 80 in Step S2 (a holding step). First, in Step S21 (a magnetic force holding step) in the example of FIG. 4, the substrate holding device 20 presses the frame 81 against the supporting component 221 with the magnetic attraction force from the magnets 241 to compressively hold the frame 81. Specifically, the controller 90 causes the holding driver 24 to exert the magnetic attraction force of the magnets 241 on the frame 81. As a specific example, the controller 90 causes the magnet movement drivers 242 to move the magnets 241 from the hold releasing positions to the holding positions. FIG. 6 is a diagram schematically illustrating one example state of the substrate holding device 20 in the magnetic force holding step. As illustrated in FIG. 6, when the magnets 241 moves to the holding positions, the magnetic attraction force from the magnets 241 is fully exerted on the frame 81, so that the frame 81 is compressively held against the supporting component 221. In the example of FIG. 6, this magnetic attraction force is schematically illustrated by dotted-line arrows.

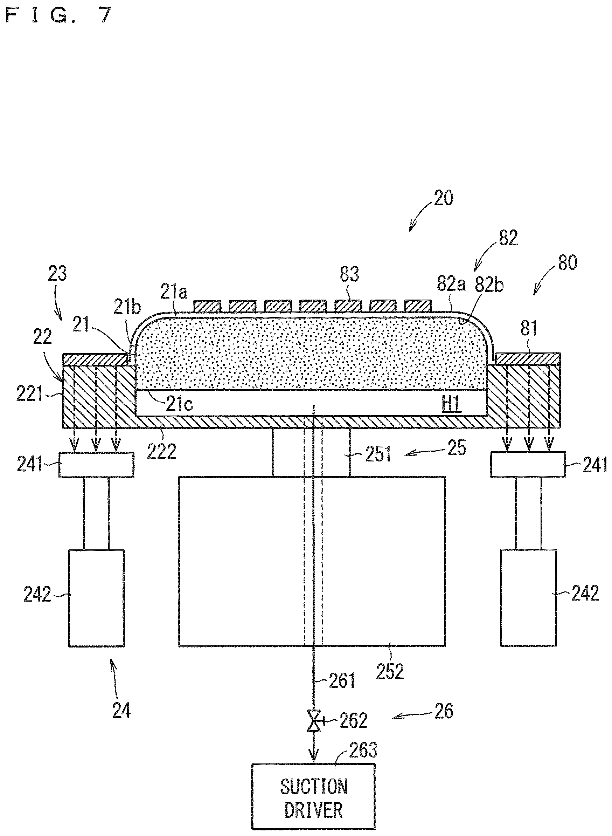

Next, in Step S22 (an adsorbing step), the substrate holding device 20 applies a negative pressure to the porous component 21 supporting the film 82 to adsorptively hold the film 82. Specifically, the controller 90 operates the suction part 26. FIG. 7 is a diagram schematically illustrating one example state of the substrate holding device 20 in the adsorbing step. In the example of FIG. 7, a flow of gas using the suction driver 263 is schematically illustrated by an arrow. The controller 90 operates the suction driver 263 with the suction valve 262 being opened. When the suction driver 263 operates, gas between the main surface 82b of the film 82 and the adsorbing surface 21a of the porous component 21 flows through an interior of the porous component 21, the void H1, and the suction pipe 261 in this order, and is sucked by the suction driver 263. Consequently, the film 82 is adsorptively held against the porous component 21.

The magnetic force holding step and the adsorbing step may be reversed in the execution order, and the adsorbing step may be performed in parallel with the magnetic force holding step.

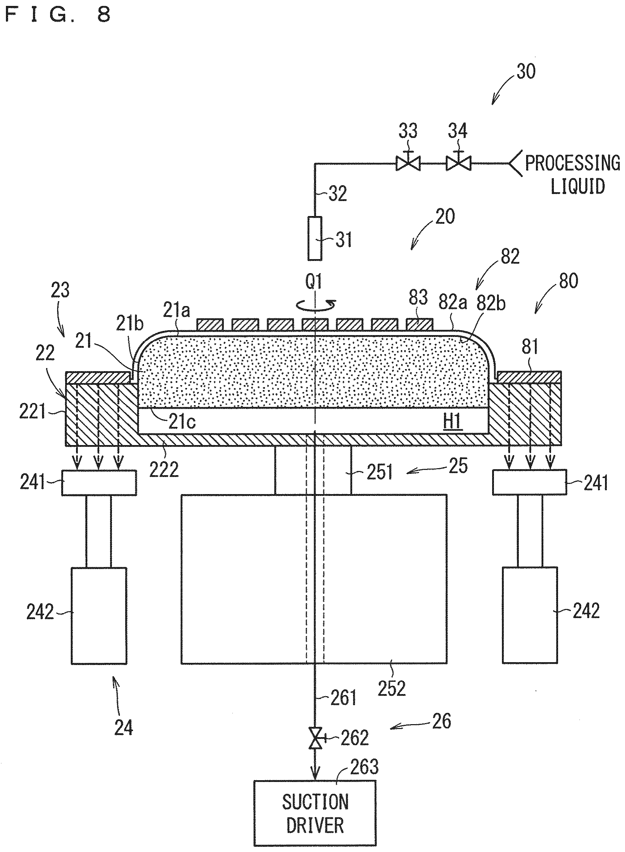

Next, in Step S3 (a processing step), the substrate processing apparatus 1 processes the framed substrate 80. FIG. 8 is a diagram schematically illustrating one example state of the substrate processing apparatus 1 in the processing step. In the process, the controller 90 causes the dispenser 30 to dispense the processing fluid toward the framed substrate 80 while causing the rotation driver 25 to rotate the framed substrate 80 about the rotation axis line Q1. A specific example of this process will be described later in detail. When the process ends, the controller 90 causes the dispenser 30 to stop dispensing the processing fluid, and causes the rotation driver 25 to stop rotating the framed substrate 80.

Next, in Step S4 (a hold releasing step), the controller 90 causes the substrate holding device 20 to release the hold of the framed substrate 80. In the example of FIG. 4, first, in Step S41 (an adsorption releasing step), the controller 90 stops operating the suction part 26. For example, the controller 90 stops operating the suction driver 263, and then closes the suction valve 262. This releases the suction of the film 82. The substrate processing apparatus 1 may include a gas supplier that generates a positive pressure in the void H1. The gas supplier generates the positive pressure in the void H1 in the adsorption releasing step, so that adsorption of the film 82 into the porous component 21 can be more reliably released.

Next, in Step S42 (a magnetic-force-hold releasing step), the controller 90 causes the holding driver 24 to reduce the magnetic attraction force of the magnets 241 exerted on the frame 81. For example, the holding driver 24 substantially eliminates the magnetic attraction force on the frame 81. As a specific example, the controller 90 causes the magnet movement drivers 242 to move the magnets 241 to the hold releasing positions. This substantially eliminates the magnetic attraction force from the magnets 241 on the frame 81, and releases the compressive hold of the frame 81.

The magnetic-force-hold releasing step and the adsorption releasing step may be reversed in the execution order, and the magnetic-force-hold releasing step may be performed in parallel with the adsorption releasing step.

Next, in Step S5 (an unloading step), the framed substrate 80 is unloaded from the chamber 10. For example, an unloader that is disposed outside the substrate processing apparatus 1 and is not illustrated performs this unloading.

As described above, the substrate processing apparatus 1 can perform processes on the framed substrate 80. Moreover, the magnets 241 of the holding driver 24 are separated from the supporting component 221, and do not rotate in unison with the holding table 23 in the substrate holding device 20. In other words, the magnets 241 do not rotate in unison with the holding table 23. Putting it differently, the rotation driver 25 does not drive the magnets 241. For example, the magnets 241 are non-rotational. Thus, the load of the rotation driver 25 can be reduced.

When an electromagnet rotates in unison with a chuck table as described in Japanese Patent Application Laid-Open No. 2010-137349, a mechanism for supplying power to the electromagnet becomes complex. In contrast, since the magnets 241 do not rotate in unison with the holding table 23 in Embodiment 1, the structure of the holding driver 24 can be more simplified.

In the aforementioned example, the magnets 241 are permanent magnets. Since the magnets 241 do not consume power herein, the holding driver 24 can exert the magnetic attraction force on the frame 81 with low power consumption. In the aforementioned example, the holding driver 24 switches between compressive hold and release of the compressive hold by the movement of the magnets 241 using the magnet movement drivers 242. This allows the holding driver 24 to switch between compressive hold and release of the compressive hold with a simple structure.

In the aforementioned example, the magnet movement drivers 242 move the magnets 241 up and down. Thus, the magnets 241 hardly protrude outward in the radial direction from a region immediately below the holding table 23. Consequently, an increase in the size of the substrate holding device 20 in the radial direction can be suppressed. In other words, since space in a region adjacent to the shaft 251 and immediately below the supporting component 221 is unused, the magnets 241 can be moved within the space, and the space can be effectively used.

When the magnetic attraction force starts to be exerted on the frame 81, there is a probability that the frame 81 moves slightly in the horizontal direction with respect to the supporting component 221. As described above, after the magnets 241 compressively hold the frame 81, the suction part 26 may adsorptively hold the film 82. Since the film 82 is not adsorptively held yet upon start of exerting the magnetic attraction force herein, even when the frame 81 moves toward the supporting component 221, the film 82 can move toward the porous component 21. Thus, the film 82 hardly becomes wrinkled, for example. Then, the suction part 26 adsorbs the film 82 after compressively holding the frame 81. Thus, the film 82 is appropriately adsorbed on the porous component 21 without any wrinkles on the film 82.

When the magnetic attraction force on the frame 81 is eliminated, there is a probability that the frame 81 moves slightly in the horizontal direction with respect to the supporting component 221. As described above, after releasing adsorption on the film 82, the compressive hold of the frame 81 may be released. Here, when the magnetic attraction force is eliminated, the film 82 is not adsorptively held yet. Even when the frame 81 moves toward the supporting component 221, the film 82 can also move toward the porous component 21. Thus, the film 82 hardly becomes crinkled, for example.

### [Dispenser]

In the example of FIG. 1, the substrate processing apparatus 1 includes the dispenser 30. The dispenser 30 dispenses the processing fluid toward the framed substrate 80 held by the substrate holding device 20. The processing fluid may be gas or liquid. Here, liquid (hereinafter, referred to as a processing liquid) is applied as the processing fluid. Examples of the processing liquid include a chemical liquid and a rinse liquid. The chemical liquid may be a liquid chemically reactive with the substrates 83 (containing impurities (e.g., particles) on the surfaces of the substrates 83). For example, the chemical liquid may be a liquid such as fluoric acid. The rinse liquid may be a liquid that rinses out a chemical liquid, for example, pure water. The rinse liquid may be an organic solvent such as isopropyl alcohol (IPA).

In the example of FIG. 1, the dispenser 30 includes a nozzle 31, a supply pipe 32, a supply valve 33, and a flow rate regulation valve 34. The nozzle 31 is disposed within the chamber 10. In the example of FIG. 1, the nozzle 31 is disposed above the framed substrate 80 held by the substrate holding device 20, and dispenses the processing liquid toward the upper surface of the framed substrate 80. The nozzle 31 may be a nozzle that dispenses the processing liquid in the form of a continuous stream, or a mist nozzle or a splay nozzle that dispenses the processing liquid in the form of droplets. Here, for example, the nozzle 31 is a nozzle that dispenses the processing liquid in the form of a continuous stream.

In the example of FIG. 1, the nozzle 31 is also connected to a downstream end of the supply pipe 32. An upstream end of the supply pipe 32 is connected to a processing liquid supply source. The processing liquid supply source includes a tank (not illustrated) that stores the processing liquid, and supplies the processing liquid to the upstream end of the supply pipe 32. In the example of FIG. 1, the supply valve 33 and the flow rate regulation valve 34 are disposed in the supply pipe 32. The supply valve 33 switches between opening and closing the supply pipe 32, and the flow rate regulation valve 34 regulates a flow rate of the processing liquid flowing through the supply pipe 32. The flow rate regulation valve 34 may be a massflow controller. These valves are controlled by the controller 90.

The dispenser 30 may be configured to sequentially supply processing liquids of a plurality of types. For example, a set of the nozzle 31, the supply pipe 32, the supply valve 33, and the flow rate regulation valve 34 may be provided for each of the types of the processing liquids.

In the example of FIG. 1, a nozzle movement driver 35 that moves the nozzle 31 is disposed in the dispenser 30. The nozzle movement driver 35 moves the nozzle 31 between a processing position and a waiting position to be described next. The processing position is a position at which the nozzle 31 dispenses the processing liquid toward the main surface (the upper surface herein) of the framed substrate 80 held by the substrate holding device 20, and is, for example, a position facing a center portion of the framed substrate 80 in the vertical direction. In the example of FIG. 1, the nozzle 31 located at the processing position is illustrated. The waiting position is a position at which the nozzle 31 does not dispense the processing liquid toward the main surface of the framed substrate 80, and is, for example, a position outward of the framed substrate 80 in the radial direction. The nozzle movement driver 35 includes, for example, a direct-acting mechanism such as an arm turning mechanism including a motor or a ball screw mechanism including a motor.

When the nozzle 31 dispenses the processing liquid toward the main surface of the rotating framed substrate 80 while being located at the processing position, the processing liquid sits on the main surface of the framed substrate 80. The processing liquid flows outward in the radial direction by centrifugal force of rotation of the framed substrate 80, and flies off outward from the outer edge of the framed substrate 80. Here, the processing liquid acts on the framed substrate 80, so that the framed substrate 80 is subjected to a process corresponding to each of the types of the processing liquids. For example, when the processing liquid is a cleaning chemical liquid, the substrates 83 are cleaned.

### [Guard part]

In the example of FIG. 1, the substrate processing apparatus 1 includes the guard part 70. The guard part 70 includes a guard 71, a cup 72, and a guard elevating driver 73. The guard 71 is of a tubular shape with respect to the rotation axis line Q1 as a central axes, and surrounds the substrate holding device 20. The guard 71 can receive various processing liquids that fly off from the outer edge of the framed substrate 80. The processing liquid flows down along the inner circumferential surface of the guard 71. The cup 72 is disposed below the guard 71, and receives the processing liquid from the guard 71. The processing liquid received by the cup 72 is discharged outside of the chamber 10 through a discharge pipe that is disposed in the cup 72 and is not illustrated.

The guard elevating driver 73 moves the guard 71 between an upper position and a lower position to be described next. The upper position is a position at which the upper end of the guard 71 is located above the framed substrate 80 held by the substrate holding device 20, and the lower position is a position at which the upper end of the guard 71 is located below the upper surface of the supporting component 221. The guard 71 receives the processing liquid that flies off from the outer edge of the framed substrate 80 while the guard 71 is located at the upper position.

### [Processing step]

Next, a specific example of the processing step (Step S3) will be described. First, the controller 90 causes the nozzle movement driver 35 to move the nozzle 31 to the processing position, causes the guard elevating driver 73 to move the guard 71 to the upper position, and causes the rotation driver 25 to rotate the framed substrate 80. Next, the controller 90 opens the supply valve 33. This causes the nozzle 31 to dispense the processing liquid toward the main surface of the rotating framed substrate 80. The processing liquid that sits on the main surface of the framed substrate 80 flows outward in the radial direction by rotation of the framed substrate 80, and flies off from the outer edge of the framed substrate 80. The processing liquid is received by the guard 71, and is discharged outside through the discharge pipe.

The processing liquid acts on the main surface of the framed substrate 80, so that the framed substrate 80 is subjected to a process corresponding to each of the types of the processing liquids. For example, the plurality of substrates 83 are cleaned. The dispenser 30 may sequentially supply processing liquids of different types to the framed substrate 80. For example, the chemical liquid and the rinse liquid may be dispensed in this order as processing liquids.

When a liquid process using the processing liquids is satisfactorily completed, the dispenser 30 stops dispensing the processing liquids. Specifically, the controller 90 closes the supply valve 33, and causes the nozzle movement driver 35 to move the nozzle 31 to the waiting position.

Next, the controller 90 causes the rotation driver 25 to increase the rotation speed of the framed substrate 80. This dries the framed substrate 80 (i.e., spin drying). When the framed substrate 80 is dried, the controller 90 causes the guard elevating driver 73 to move the guard 71 to the lower position.

As described above, the substrate processing apparatus 1 can perform processes on the framed substrate 80.

### [Holding driver]

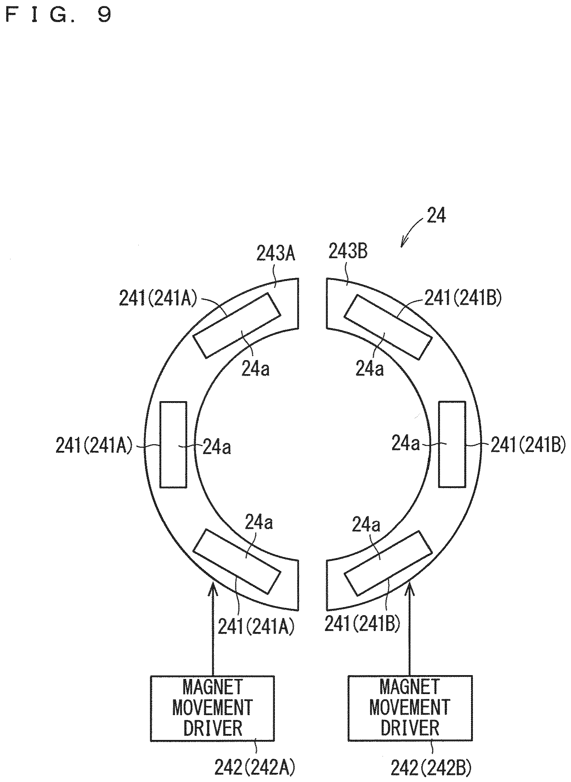

Next, an example of a more specific structure of the holding driver 24 will be described. FIG. 9 is a plan view schematically illustrating an example structure of the holding driver 24. As illustrated in FIG. 9, the holding driver 24 may include a plurality of magnets 241. In the example of FIG. 9, the magnets 241 are arranged at intervals in a circumferential direction. The magnets 241 may be arranged at regular intervals. While six magnets 241 are provided in the example of FIG. 9, the number of the magnets 241 is any. In the example of FIG. 9, the magnets 241 are of a long shape in a plan view. The magnets 241 may be of a rectangular parallelepiped. Each of the magnets 241 is disposed in an attitude such that its longitudinal direction is along a circumferential direction.

Since the plurality of magnets 241 are arranged in such a manner, the magnetic attraction force exerted on the frame 81 can be regulated by, for example, the number of the magnets 241 and the size of each of the magnets 241. Thus, designing can be made more easily. The amount of usage of magnets can be reduced more than that of an annular magnet surrounding the rotation axis line Q1.

In the example of FIG. 9, a plurality of the magnet movement drivers 242 are disposed. Each of the magnet movement drivers 242 moves one or more magnets 241. In the example of FIG. 9, a first magnet movement driver 242A and a second magnet movement driver 242B are indicated as the plurality of magnet movement drivers 242. The first magnet movement driver 242A moves one or more magnets 241A of the plurality of magnets 241. In the example of FIG. 9, the first magnet movement driver 242A moves the plurality of (e.g., three) magnets 241A in unison. In the example of FIG. 9, a holding component 243A holds the plurality of magnets 241A in unison. The holding component 243A is, for example, arc-shaped in a plan view, and houses the plurality of magnets 241A. The holding component 243A is made of, for example, a synthetic resin.

The second magnet movement driver 242B moves one or more magnets 241B different from the magnets 241A of the plurality of magnets 241. In the example of FIG. 9, the second magnet movement driver 242B moves the plurality of (e.g., three) magnets 241B in unison. In the example of FIG. 9, a holding component 243B holds the plurality of magnets 241B in unison. The holding component 243B is, for example, arc-shaped in a plan view, and houses the plurality of magnets 241B. The holding component 243B is made of, for example, a synthetic resin.

As described above, when the plurality of magnet movement drivers 242 are provided, the number of the magnets 241 moved by each of the magnet movement drivers 242 can be reduced. Thus, the load of each of the magnet movement drivers 242 can be reduced. Consequently, a smaller movement driver can be employed as the magnet movement driver 242.

Polarities of the pole faces 24a of adjacent two of the plurality of magnets 241 may be different from each other. In other words, the plurality of magnets 241 are arranged in the circumferential direction with alternately different polarities facing the supporting component 221. This can increase the magnetic gradient between each of the magnets 241 and the frame 81. Consequently, the plurality of magnets 241 can increase the whole magnetic attraction force to be exerted on the frame 81.

### [Embodiment 2]

A structure of the substrate holding device 20 according to Embodiment 2 is identical to that according to Embodiment 1. It is to be noted that the holding driver 24 exerts, on the frame 81, the magnetic attraction force corresponding to the weight of the framed substrate 80. Specifically, the holding driver 24 exerts, on the frame 81, the magnetic attraction force larger as the weight of the framed substrate 80 is greater.

Assumed herein is dicing rings of a plurality of types which include the frames 81 of different thicknesses. Differences in thickness of the frame 81 between the dicing rings of a plurality of types are, for example, several hundred µm. Since a thick frame 81 is heavier than a thin frame 81, the framed substrate 80 is heavier as the frame 81 is thicker.

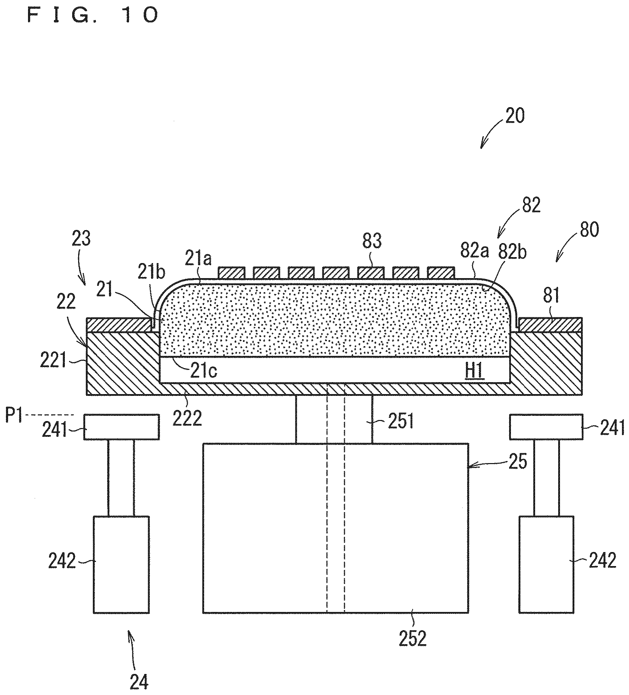

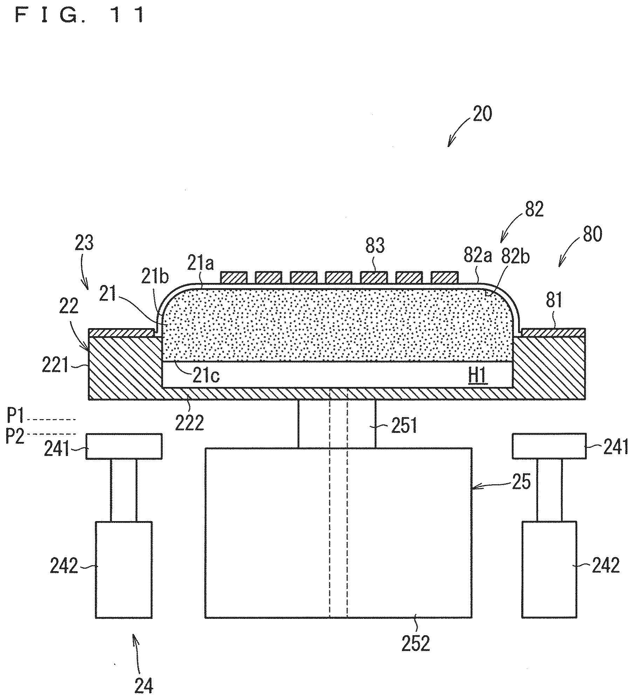

FIGS. 10 and 11 are diagrams schematically illustrating examples of the substrate holding device 20 according to Embodiment 2. The thicknesses of the frames 81 differ between FIGS. 10 and 11. Since the frame 81 in FIG. 10 is thicker than the frame 81 in FIG. 11, the framed substrate 80 in FIG. 10 is heavier than the framed substrate 80 in FIG. 11.

In the example of FIGS. 10 and 11, the holding driver 24 includes the magnet movement drivers 242. Unlike Embodiment 1, the magnet movement drivers 242 move the magnets 241 to holding positions corresponding to the weight of the framed substrate 80. The holding positions are set closer to the frame 81 as the framed substrate 80 is heavier. This allows the holding driver 24 to exert, on the frame 81, the magnetic attraction force larger as the framed substrate 80 is heavier. The magnet movement driver 242 includes, for example, a motor, and a power transmitter that transmits a driving force of the motor to the magnet 241. The power transmitter is, for example, a ball screw mechanism. The magnet movement driver 242 is also referred to as an electric actuator, and can stop the magnet 241 at any position within a certain moving range. "Any position" herein means any position within a resolution of the magnet movement driver 242.

A correspondence between the weight of the framed substrate 80 and the magnetic attraction force on the frame 81 is set in advance by, for example, simulations or experiments. Correspondence data indicating the correspondence is stored in advance in, for example, the storage 94. The correspondence data may include a correspondence between a type of the framed substrate 80 and the holding positions. For example, the correspondence data may include holding positions P1 when the framed substrate 80 is relatively heavy, and holding positions P2 when the framed substrate 80 is relatively light. The holding positions P1 are set closer to the frame 81 than the holding positions P2 (see FIGS. 10 and 11). For example, the holding positions P1 are positions between the supporting component 221 and the holding positions P2. Conversely speaking, the holding positions P2 are set closer to the hold releasing positions than the holding positions P1.

Substrate data on the weight of the framed substrate 80 is input to the controller 90 before processing. The substrate data may include information indicating the type of the framed substrate 80 as information on the weight. This substrate data may be input to the controller 90 through an input by the user using a user interface that is not illustrated. Alternatively, the substrate data may be transmitted from a device upstream of the substrate processing apparatus 1 to the controller 90. The substrate data is input to the controller 90 before at least the magnetic force holding step (Step S21). For example, the substrate data is input to the controller 90 before the loading step (Step S1).

The controller 90 sets a magnetic attraction force (e.g., holding positions) corresponding to the weight of the framed substrate 80, based on the substrate data and the correspondence data. Then, the controller 90 causes the holding driver 24 to exert the set magnetic attraction force on the frame 81 in the magnetic force holding step (Step S21). For example, the controller 90 causes the magnet movement drivers 242 to move the magnets 241 to the set holding positions.

As described above, the holding driver 24 applies, to the frame 81, the magnetic attraction force larger as the framed substrate 80 is heavier in Embodiment 2. Thus, the substrate holding device 20 can more appropriately hold the framed substrate 80 even when the framed substrate 80 is heavy. In contrast, when the framed substrate 80 is light, the holding driver 24 applies a smaller magnetic attraction force to the frame 81. This can avoid a situation where an excessive magnetic attraction force is applied to the frame 81. Thus, the substrate holding device 20 can exert the magnetic attraction force on the frame 81 with a high degree of efficiency. For example, when the holding driver 24 includes the magnet movement drivers 242, since the holding positions P2 are closer to the hold releasing positions, a moving distance of the magnets 241 from the hold releasing positions to the holding positions P2 are relatively short. Thus, the power consumption of the magnet movement drivers 242 when the framed substrate 80 is light can be reduced. Alternatively, in the case where the magnets 241 are electromagnets, the current flowing through the magnets 241 when the framed substrate 80 is light is low. Thus, the power consumption of the holding driver 24 can be reduced.

While the substrate holding device 20, the substrate processing apparatus 1, and the method of processing a substrate are described in detail above, the description is in all aspects illustrative and does not restrict this disclosure. The aforementioned various modifications are applicable in combination unless any contradiction occurs. Therefore, numerous modifications and variations that have not yet been exemplified are devised without departing from the scope of the present disclosure.

The present disclosure includes the following aspects.

A first aspect is a substrate holding device including: a porous component including an adsorbing surface that adsorbs a film of a framed substrate, the framed substrate including an annular frame, the film attached to an interior of the frame, and a substrate provided on the film; a supporting component surrounding the porous component and supporting the frame; a rotation driver rotating the supporting component and the porous component in unison; and a holding driver including at least one magnet disposed opposite to the frame with respect to the supporting component and separated from the supporting component, the holding driver compressively holding the frame against the supporting component by a magnetic force of the magnet.

A second aspect is the substrate holding device according to the first aspect, wherein the magnet is a permanent magnet, the holding driver includes a magnet movement driver, and the magnet movement driver moves the magnet between a holding position at which the frame is compressively held against the supporting component by the magnetic force and a hold releasing position which is farther from the supporting component than the holding position and at which a compressive hold of the frame is released.

A third aspect is the substrate holding device according to the second aspect, wherein the holding position and the hold releasing position are aligned in a vertical direction, and the magnet movement driver moves the magnet up and down between the holding position and the hold releasing position.

A fourth aspect is the substrate holding device according to any one of the first to third aspects, wherein the holding driver includes the at least one magnet including a plurality of magnets, and the plurality of magnets are annularly arranged in a circumferential direction of the frame.

A fifth aspect is the substrate holding device according to the fourth aspect, wherein pole faces of adjacent two of the plurality of magnets are different from each other.

A sixth aspect is the substrate holding device according to the fourth or fifth aspect, wherein the holding driver includes: a first magnet movement driver that moves one or more first magnets of the plurality of magnets; and a second magnet movement driver that moves one or more second magnets of the plurality of magnets, the second magnets being different from the first magnets.

A seventh aspect is the substrate holding device according to any one of the first to sixth aspects, wherein the holding driver presses the frame against the supporting component by the magnetic force larger as the framed substrate is heavier.

An eighth aspect is the substrate holding device according to any one of the first to seventh aspects, wherein the rotation driver includes a hollow shaft, and a negative pressure is applied to the porous component through an interior of the hollow shaft.

A ninth aspect is a substrate processing apparatus including: the substrate holding device according to any one of the first to eighth aspects; and a dispenser that dispenses a processing fluid toward the framed substrate held by the substrate holding device.

A tenth aspect is a method of processing a substrate, the method including: a magnetic force holding step of compressively holding an annular frame of a framed substrate by pressing the frame against a supporting component by a magnetic force of a magnet, the framed substrate including the frame, a film attached to the frame, and the substrate provided on the film, the magnet being separated from the supporting component; an adsorbing step of adsorptively holding the film by applying a negative pressure to a porous component supporting the film; and a processing step of rotating the porous component, the supporting component, and the substrate in unison, and supplying a processing fluid to the framed substrate.

An eleventh aspect is the method according to the tenth aspect, wherein the adsorbing step is performed after the magnetic force holding step.

According to the first, ninth, and tenth aspects, since the magnet is separated from the supporting component, the magnet is not rotated by the rotation driver. Thus, the load of the rotation driver can be reduced.

According to the second aspect, the holding driver can switch between compressive hold and release of the compressively hold with a simple structure.

According to the third aspect, an increase in the size of the substrate holding device in the radial direction can be suppressed.

According to the fourth aspect, the amount of usage of magnets can be reduced more than that of an annular magnet.

According to the fifth aspect, the whole magnetic force exerted from a plurality of magnets on the frame can be increased.

According to the sixth aspect, a smaller magnet movement driver can be employed.

According to the seventh aspect, the substrate holding device can more appropriately hold the framed substrate even when the framed substrate is heavy. In contrast, when the framed substrate is light, the substrate holding device can hold the framed substrate with a higher degree of efficiency.

According to the eighth aspect, a negative pressure can be applied to the porous component with a simple structure.

According to the eleventh aspect, since the film is adsorptively held after the frame is compressively held, wrinkles on the film can be suppressed.

## Claims

1. A substrate holding device, comprising:
a porous component (21) including an adsorbing surface (21a) that adsorbs a film (82) of a framed substrate (80), the framed substrate (80) including an annular frame (81), the film (82) attached to an interior of the frame (81), and a substrate (83) provided on the film (82);
a supporting component (221) surrounding the porous component (21) and supporting the frame (81);
a rotation driver (25) rotating the supporting component (221) and the porous component (21) in unison; and
a holding driver (24) including at least one magnet (241) disposed opposite to the frame (81) with respect to the supporting component (221) and separated from the supporting component (221), the holding driver (24) compressively holding the frame (81) against the supporting component (221) by a magnetic force of the magnet (241).

2. The substrate holding device according to claim 1,
wherein the magnet (241) is a permanent magnet,
the holding driver (24) includes a magnet movement driver (242), and
the magnet movement driver (242) moves the magnet (241) between a holding position at which the frame (81) is compressively held against the supporting component (221) by the magnetic force and a hold releasing position which is farther from the supporting component (221) than the holding position and at which a compressive hold of the frame (81) is released.

3. The substrate holding device according to claim 2,
wherein the holding position and the hold releasing position are aligned in a vertical direction, and
the magnet movement driver (242) moves the magnet (241) up and down between the holding position and the hold releasing position.

4. The substrate holding device according to any one of claims 1 to 3,
wherein the holding driver (24) includes the at least one magnet (241) comprising a plurality of magnets (241), and
the plurality of magnets (241) are annularly arranged in a circumferential direction of the frame (81).

5. The substrate holding device according to claim 4,
wherein pole faces of adjacent two of the plurality of magnets (241) are different from each other.

6. The substrate holding device according to claim 4 or 5,
wherein the holding driver (24) includes:
a first magnet movement driver (242A) that moves one or more first magnets (241A) of the plurality of magnets (241); and
a second magnet movement driver (242B) that moves one or more second magnets (241B) of the plurality of magnets (241), the second magnets (241B) being different from the first magnets (241A).

7. The substrate holding device according to any one of claims 1 to 6,
wherein the holding driver (24) presses the frame (81) against the supporting component (221) by the magnetic force larger as the framed substrate (80) is heavier.

8. The substrate holding device according to any one of claims 1 to 7,
wherein the rotation driver (25) includes a hollow shaft, and
a negative pressure is applied to the porous component (21) through an interior of the hollow shaft.

9. A substrate processing apparatus, comprising:
the substrate holding device (20) according to any one of claims 1 to 8; and
a dispenser (30) that dispenses a processing fluid toward the framed substrate (80) held by the substrate holding device (20).

10. A method of processing a substrate, the method comprising:
compressively holding an annular frame (81) of a framed substrate (80) by pressing the frame (81) against a supporting component (221) by a magnetic force of a magnet (241), the framed substrate (80) including the frame (81), a film (82) attached to the frame (81), and the substrate (83) provided on the film (82), the magnet (241) being separated from the supporting component (221);
adsorptively holding the film (82) by applying a negative pressure to a porous component (21) supporting the film (82); and
rotating the porous component (21), the supporting component (221), and the substrate (83) in unison, and supplying a processing fluid to the framed substrate (80).

11. The method according to claim 10,
wherein the adsorptively holding is performed after the compressively holding.
